# EUROPÄISCHE PATENTSCHRIFT

(11) **EP 0 620 957 B1**
(45) Veröffentlichungstag und Bekanntmachung des Hinweises auf die Patenterteilung: **12.02.1997**
(21) Anmeldenummer: 93923450.6
(22) Anmeldetag: 28.10.1993
(51) Int. Cl.: H03K 17/08

(54) **SCHALTUNG ZUM SCHUTZ EINES MOSFET-LEISTUNGSTRANSISTORS**
CIRCUIT FOR PROTECTING A MOSFET POWER TRANSISTOR
CIRCUIT DE PROTECTION D'UN TRANSISTOR DE PUISSANCE MOS A EFFET DE CHAMP

(30) Priorität: 06.11.1992 DE 4237489
(43) Veröffentlichungstag der Anmeldung: 26.10.1994
(73) Patentinhaber: ROBERT BOSCH GMBH, 70442 Stuttgart (DE)
(72) Erfinder: TOPP, Rainer, D-72768 Reutlingen (DE); SCHMID, Roland, D-72116 Moessingen (DE); OERTEL, Dagmar, D-70597 Stuttgart (DE)
(74) Vertreter: Friedmann, Jürgen, Dr.-Ing.
(86) Internationale Anmeldenummer: DE9301029
(87) Internationale Veröffentlichungsnummer: WO9411947

(56) Entgegenhaltungen:
- EP-A- 0 442 561
- SIEMENS COMPONENTS Bd. 24, Nr. 6 , Dezember 1989 , MUNCHEN DE Seiten 228 - 232 BRAUSCHKE ET AL. 'TEMPFET - One step closer to an ideal power semiconductor switch'
- IBM TECHNICAL DISCLOSURE BULLETIN. Bd. 16, Nr. 1 , Juni 1973 , ARMONK,NY,US Seiten 317 - 318 CHANG 'Integrated delay circuit/noise rejection circuit'

## Beschreibung

Die Erfindung betrifft eine Schaltung zum Schutz eines MOSFET-Leistungstransistors mit variabler Eingangsimpedanz nach dem Oberbegriff des Anspruchs 1.

Es sind bereits Schutzschaltungen für MOSFET-Leistungstransistoren , insbesondere zum Schutz dieser Transistoren gegen Kurzschluß, bekannt. Zur Entkopplung der Schutzschaltung von der Treiberschaltung ist ein Gate-Vorwiderstand erforderlich. Es ist jedoch nachteilig, wenn kurze Schaltzeiten realisiert werden sollen, daß der Gate-Vorwiderstand niederohmig sein muß, das heißt, der Eingangsstrom wird sehr groß. Soll der statische Eingangsstrom im Fehlerfall reduziert werden, kann dies nur mit einem hochohmigen Widerstand erzielt werden.

Der Erfindung liegt die Aufgabe zugrunde, eine Schutzschaltung für MOSFET-Leistungstransistoren anzugeben, die mittels variabler Eingangsimpedanz der Ansteuerschaltung die Spannungssteilheit erhöht, das heißt, die Verzögerungszeit und damit die Schaltzeit wird deutlich reduziert.

Erfindungsgemäß wird die Aufgabe durch die kennzeichnenden Merkmale des Anspruchs 1 oder 4 gelöst.

Durch die Schaltung ist es in vorteilhafter Weise möglich, die Schaltverlustleistung zu reduzieren und gleichzeitig die maximal mögliche Schaltfrequenz zu erreichen. Des weiteren werden gleichwertige Schaltverhältnisse mit geringeren Anforderungen an die Treiberschaltung erzielt.

Weitere Vorteile ergeben sich aus den in den abhängegen Ansprüchen aufgeführten Merkmalen.

Die Erfindung soll nachfolgend in Ausführungsbeispielen anhand der zugehörigen Zeichnungen näher erläutert werden. Es zeigen:
- Figur 1: ein MOSFET-Leistungstransistor mit einer Schutzschaltung;
- Figur 2: ein MOSFET-Leistungstransistor mit einer weiteren Schutzschaltung;
- Figur 3: ein MOSFET-Leistungstransistor mit einer weiteren Schutzschaltung und
- Figur 4: ein Blockschaltbild für weitere Schutzschaltungen.

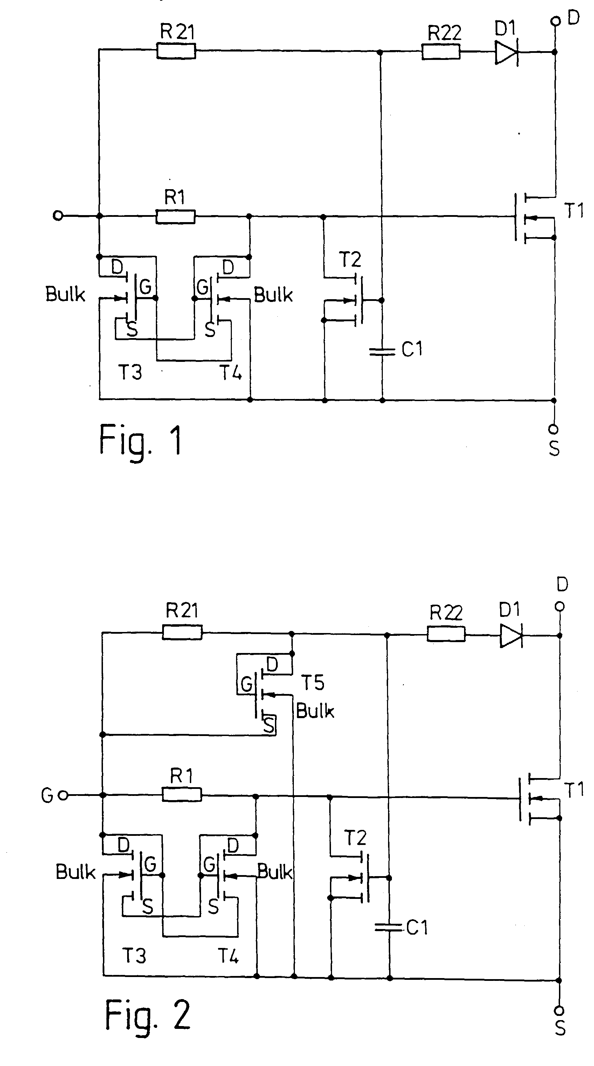

Bei dem in Figur 1 dargestellten Schaltbild ist mit T1 ein aus einer Vielzahl zueinander parallel geschalteter Transistoren bestehender MOSFET-Leistungstransistor, mit S seine Sourceanschlußklemme und mit D seine Drainanschlußklemme bezeichnet. Die Eingangsklemme G des MOSFET-Leistungstransistors T1 ist über einen ersten ohmschen Widerstand R1 mit seinem Polysilizium-Gate verbunden.

Ein erster MOSFET-Hilfstransistor T2 ist mit seiner Sourceelektrode an die Sourceelektrode des MOSFET-Leistungstransistors T1 angeschlossen. Die Drainelektrode des MOSFET-Hilfstransistors T2 ist an das Polysilizium-Gate des MOSFET-Leistungstransistors T1 angeschlossen. Das Polysilizium-Gate des MOSFET-Hilfstransistors T2 ist einerseits über einen zweiten ohmschen Widerstand R21 mit der Eingangsklemme G und andererseits über die Reihenschaltung eines dritten ohmschen Widerstands R22 und einer Schutzdiode D1 mit der Drainanschlußklemme D des MOSFET-Leistungstransistors T1 verbunden. Des weiteren ist das Polysilizium-Gate des MOSFET-Hilfstransistors T2 mit dem einen Belag einer Kapazität C1 verbunden, deren anderer Belag an die Sourceelektrode des MOSFET-Hilfstransistors T2 angeschlossen ist.

Ein zweiter, als Diode verschalteter, MOSFET-Hilfstransistor T3 ist mit seiner Bulkelektrode an die Sourceelektrode des MOSFET-Leistungstransistors T1 angeschlossen. Die Sourceelektrode des MOSFET-Hilfstransistors T3 ist mit der Gateelektrode eines dritten MOSFET-Hilfstransistors T4 und dem Polysilizium-Gate des MOSFET-Leistungstransistors T1 verbunden. Die Drainelektrode des MOSFET-Hilfstransistors T3 ist an die Eingangsklemme G des MOSFET-Leistungstransistors T1 angeschlossen. Die Gateelektrode des zweiten MOSFET-Hilfstransistors T3 ist einerseits mit der Drainelektrode des MOSFET-Hilfstransistors T3 und andererseits mit der Sourceelektrode eines dritten MOSFET-Hilfstransistors T4 verbunden. Die Drainelektrode des MOSFET-Hilfstransistors T4 ist an das Polysilizium-Gate des MOSFET-Leistungstransistors T1 angeschlossen. Die Bulkelektrode des MOSFET-Hilfstransistors T4 ist mit der Sourceelektrode des MOSFET-Leistungstransistors T1 verbunden.

Die Wirkungsweise der Schaltungsanordnung nach Figur 1 ist folgende:

Im ausgeschalteten Zustand liegt zwischen Gate G und Source S die Spannung UGS = 0 V. Zwischen Drain D und Source S liegt die Betriebsspannung. Da die Diode D1 in Sperrichtung gepolt ist, werden das Gate des Hilfstransistors T2 und die Kapazität C1 entladen. Damit sind die Gate-Source-Spannungen der Hilfstransistoren T2, T3 und T4 ebenfalls UGS2 = UGS3 = UGS4 = 0 V.

Wird die Anordnung eingeschaltet, d.h. UGS wird auf typisch +5 V erhöht, so wird die Eingangskapazität des Leistungstransistors T1 über den Widerstand R1 aufgeladen und die Gate-Source-Spannung UGS1 des Leistungstransistors T1 steigt. Überschreitet der Spannungsabfall UR1 am Widerstand R1 Schwellspannung des Hilfstransistors T3 so wird dieser leitend, d.h. zu Beginn der Einschaltphase entspricht der effektive Eingangswiderstand der Parallelschaltung des Widerstandes R1 und des Hilfstransistors T3. Mit steigender Gate-Source-Spannung UGS1 des Leistungstransistors T1 sinkt der Spannungsabfall UR1 am Widerstand R1. Unterschreitet die Spannung UR1 die Schwellspannung des Hilfstransistors T3, so geht dieser in den Sperrzustand über, und der effektive Eingangswiderstand ist nun der Widerstand R1.

Im eingeschalteten Zustand sind die Spannungen UGS und UGS1 gleich groß, d.h. am Widerstand R1 fällt keine Spannung ab und die Hilfstransistoren T3 und T4 sind inaktiv.

Wird die Anordnung mittels UGS = 0 V ausgeschaltet, so wird die Eingangskapazität des Leistungstransistors T1 über den Widerstand R1 entladen. Solange der Spannungsabfall an R1 größer als die Schwellspannung des Hilfstransistors T4 ist, wird der Hilfstransistor T4 eingeschaltet und der effektive Eingangswiderstand reduziert.

Wird die Schutzschaltung aktiviert, d.h. der Hilfstransistor T2 eingeschaltet, dann wird die Eingangskapazität des Leistungstransistors T1 über den Hilfstransistor T2 entladen. Dieser Zustand ist nur stabil, wenn die Gate-Source-Spannung UGS mindestens so groß wie die Schwellspannung des Hilfstransistors T2 ist und außerdem die Gate-Source-Spannung UGS1 des Leistungstransistors T1 kleiner als die Schwellspannung von T1 ist.

Ist der Hilfstransistor T2 eingeschaltet, d.h. die Schutzschaltung ist aktiviert, so fließt ein statischer Eingangsstrom IG = (UGS-UGS1)/R1.

Soll der Lade- und Entladevorgang der Kapazität C1 entkoppelt werden, so ist gemäß Figur 2 ein vierter MOSFET-Hilfstransistor T5 vorgesehen.

Die Drainelektrode des MOSFET-Hilfstransistors T5 ist einerseits über den ohmschen Widerstand R21 mit der Eingangsklemme G und andererseits über die Reihenschaltung des ohmschen Widerstandes R22 und der Schutzdiode D1 mit der Drainanschlußklemme D des MOSFET-Leistungstransistors T1 verbunden. Des weiteren ist die Drainelektrode des MOSFET-Hilfstransistors T5 mit dessen Gateelektrode verbunden. Die Sourceelektrode des MOSFET-Hilfstransistors T5 ist an die Eingangsklemme G des MOSFET-Leistungstransistors T1 angeschlossen. Die Bulkelektrode des MOSFET-Hilfstransistors T5 ist mit der Sourceanschlußklemme S des MOSFET-Leistungstransistors verbunden.

In dieser Anordnung erfolgt der Ladevorgang der Kapazität C1 beim Einschalten des Leistungstransistors T1 über den Widerstand R21. Beim Ausschalten des Leistungstransistors T1 wird der Entladevorgang von der Kapazität C1 beschleunigt, solange der Spannungsabfall am Widerstand R21 größer als die Schwellspannung des Hilfstransistors T5 ist.

Somit ist eine Erweiterung des zulässigen Tastverhältnisbereiches möglich.

Je nach gewünschtem Schaltverhalten können die MOSFET-Hilfstransistoren T3, T4 und T5 einzeln oder in Kombination verwendet werden.

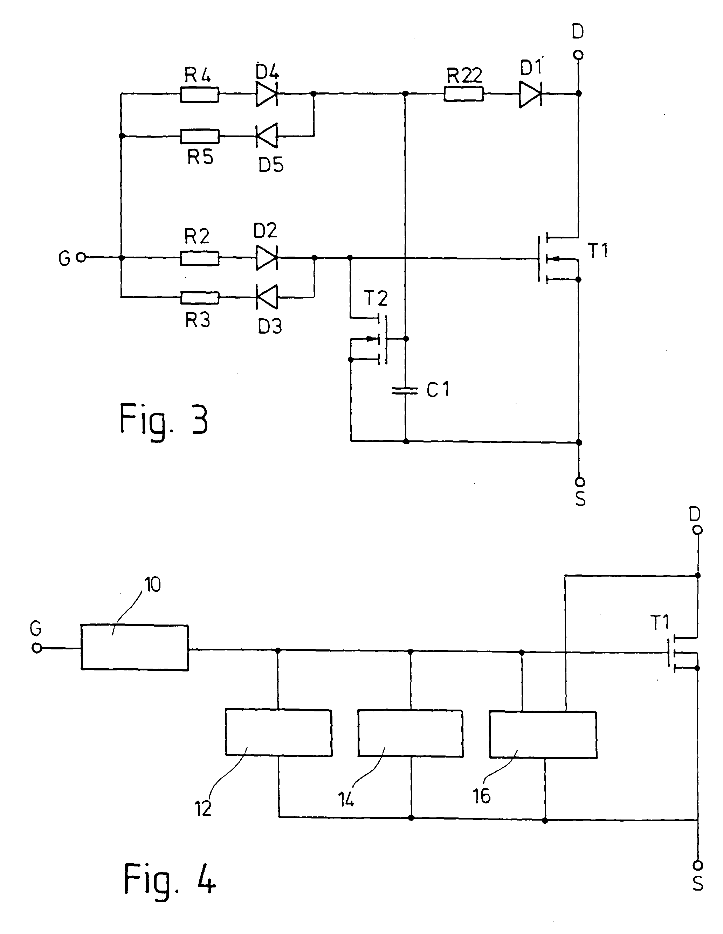

Da die MOSFET-Hilfstransistoren T3, T4 und T5 die gleiche Funktion wie eine Reihenschaltung von ohmschem Widerstand und Diode aufweisen, kann die Schutzschaltung auch gemäß Figur 3 aufgebaut sein. Dabei ist zwischen dem Polysilizium-Gate des MOSFET-Leistungstransistors T1 und der Eingangsklemme G eine Parallelschaltung der Reihenschaltungen des ohmschen Widerstandes R2 und der Diode D2 bzw. des ohmschen Widerstandes R3 und der Diode D3 vorgesehen. Die Diode D2 ist dabei in Durchlaßrichtung und die Diode D3 in Sperrichtung geschaltet.

Eine weitere Parallelschaltung der Reihenschaltungen des ohmschen Widerstandes R4 und der Diode D4 bzw. des ohmschen Widerstandes R5 und der Diode D5 ist zwischen der Eingangsklemme G und der Reihenschaltung des ohmschen Widerstandes R22 und der Diode D1 angeordnet. Die Diode D4 ist in Durchlaßrichtung und die Diode D5 in Sperrichtung geschaltet.

Die Reihenschaltungen der Widerstände/Diodenkombinationen R2/D2; R3/D3; R4/D4 und R5/D5 können wahlweise vollständig oder aber auch teilweise vorgesehen sein.

Die im Beispiel genannten Erläuterungen bezogen sich auf eine Schutzschaltung im Kurzschlußfall.

Wie in Figur 4 im Blockschaltbild dargestellt, ist die dynamische Reduktion der Eingangsimpedanz mit Hilfe der MOSFET-Hilfstransistoren T3 und T4 (hier mit 10 angedeutet) auch in Verbindung mit anderen Schutzschaltungen für den MOSFET-Leistungstransistor T1 einsetzbar. So kann beispielsweise eine Übertemperaturschutzschaltung 12, eine Überstromschutzschaltung 14 oder eine Überspannungsschutzschaltung 16 bzw. eine Kombination dieser aufgebaut werden.

Die Erfindung beschränkt sich nicht auf das angegebene Beispiel. So ist insbesondere an Stelle eines normalen POWER-MOSFET-Leistungstransistors ein Sense-FET-Leistungstransistor einsetzbar.

Darüber hinaus sind die Anordnungen sowohl für Low-Side-Schalter als auch für High-Side-Schalter einsetzbar.

Die gesamte Schaltungsanordnung ist in einem, eine erste und eine zweite Hauptoberfläche aufweisenden, scheibenförmigen, einkristallinen, aus Silizium bestehenden Halbleiterkörper monolithisch integriert, in dem die verschiedenen Schaltungs- bzw. Schutzelemente eindiffundiert sind.

## Patentansprüche

1. Schaltung zum Schutz eines MOSFET-Leistungstransistors (T1) mit einer Vielzahl zueinander parallel geschalteter Teiltransistoren, mit einer Sourceanschlußklemme (S), einer Drainanschlußklemme (D), wobei eine Eingangsklemme (G) des MOSFET-Leistungstransistors (T1) über einen ersten ohmschen Widerstand (R1) mit seinem Polysilizium-Gate verbunden ist, ein erster MOSFET-Hilfstransistor (T2) mit seiner Sourceelektrode an die Sourceelektrode des MOSFET-Leistungstransistors (T1) und mit seiner Drainelektrode an das Polysilizium-Gate des MOSFET-Leistungstransistors (T1) angeschlossen ist, das Polysilizium-Gate des ersten MOSFET-Hilfstransistors (T2) einerseits über einen zweiten ohmschen Widerstand (R21) mit der Eingangsklemme (G) und andererseits über eine Reihenschaltung eines dritten Widerstandes (R22) und einer Schutzdiode (D1) mit der Drainanschlußklemme (D) des MOSFET-Leistungstransistors (T1) verbunden ist, das Polysilizium-Gate des ersten MOSFET-Hilfstransistors (T2) mit dem einen Belag einer Kapazität (C1) verbunden ist, deren anderer Belag an die Sourceelektrode des MOSFET-Hilfstransistors (T2) angeschlossen ist, **dadurch gekennzeichnet,** daß ein zweiter MOSFET-Hilfstransistor (T3) mit seiner Bulkelektrode an die Sourceelektrode des MOSFET-Leistungstransistors (T1) angeschlossen ist, die Sourceelektrode des zweiten MOSFET-Hilfstransistors (T3) mit der Gateelektrode eines dritten MOSFET-Hilfstransistors (T4) und dem Polysilizium-Gate des MOSFET-Leistungstransistors (T1) verbunden ist, die Drainelektrode des zweiten MOSFET-Hilfstransistors (T3) an die Eingangsklemme (G) des MOSFET-Leistungstransistors (T1) angeschlossen ist und die Gateelektrode des zweiten MOSFET-Hilfstransistors (T3) einerseits mit der Drainelektrode des zweiten MOSFET-Hilfstransistors (T3) und andererseits mit der Sourceelektrode des dritten MOSFET-Hilfstransistors (T4) verbunden ist, die Drainelektrode des dritten MOSFET-Hilfstransistors (T4) an das Polysilizium-Gate des MOSFET-Leistungstransistors (T1) angeschlossen ist, sowie die Bulkelektrode des dritten MOSFET-Hilfstransistors (T4) mit der Sourceelektrode des MOSFET-Leistungstransistors (T1) verbunden ist.

2. Schaltung nach Anspruch 1, **dadurch gekennzeichnet,** daß die Drain- und Gateelektrode eines vierten MOSFET-Hilfstransistors (T5) einerseits über den ohmschen Widerstand (R21) mit der Eingangsklemme (G) und andererseits über die Reihenschaltung des ohmschen Widerstandes (R22) mit der Schutzdiode (D1) und der Drainanschlußklemme (D) des MOSFET-Leistungstransistors (T1) verbunden sind, die Sourceelektrode des MOSFET-Hilfstransistors (T5) an die Eingangsklemme (G) und die Bulkelektrode des MOSFET-Hilfstransistors (T5) an die Sourceanschlußklemme (S) des MOSFET-Leistungstransistors (T1) angeschlossen ist.

3. Schaltung nach einem der vorhergehenden Ansprüche, **dadurch gekennzeichnet,** daß die MOSFET-Hilfstransistoren (T3, T4, T5) in frei wählbaren, beliebigen Kombinationen angeordnet sind.

4. Schaltung zum Schutz eines MOSFET-Leistungstransistors (T1) mit einer Vielzahl zueinander parallel geschalteter Teiltransistoren, mit einer Sourceanschlußklemme (S), einer Drainanschlußklemme (D), wobei eine Eingangsklemme (G) des MOSFET-Leistungstransistors (T1) über einen ersten ohmschen Widerstand (R2) mit seinem Polysilizium-Gate verbunden ist, ein erster MOSFET-Hilfstransistor (T2) mit seiner Sourceelektrode an die Sourceelektrode des MOSFET-Leistungstransistors (T1) und mit seiner Drainelektrode an das polysilizium-Gate des MOSFET-Leistungstransistors (T1) angeschlossen ist, das Polysilizium-Gate des ersten MOSFET-Hilfstransistors (T2) einerseits über einen zweiten ohmschen Widerstand (R4) mit der Eingangsklemme (G) und andererseits über eine Reihenschaltung eines dritten Widerstandes (R22) und einer Schutzdiode (D1) mit der Drainanschlußklemme (D) des MOSFET-Leistungstransistors (T1) verbunden ist, das Polysilizium-Gate des ersten MOSFET-Hilfstransistors (T2) mit dem einen Belag einer Kapazität (C1) verbunden ist, deren anderer Belag an die Sourceelektrode des ersten MOSFET-Hilfstransistors (T2) angeschlosssen ist, **dadurch gekennzeichnet,** daß zwischen dem ersten Widerstand (R2) und dem Drainanschluß des ersten Hilfstransistors (T2) bzw. dem Polysilizium-Gate des MOSFET-Leistungstransistors (T1) eine zweite Diode (D2) angeordnet ist und daß zur Reihenschaltung des ersten Widerstands (R2) mit der zweiten Diode (D2) eine weitere Reihenschaltung eines vierten Widerstands (R3) mit einer dritten Diode (D3) parallelgeschaltet ist, wobei die zweite und dritte Diode (D2 bzw. D3) mit zueinander entgegengesetzten Polungen angeordnet sind.

5. Schaltung nach Anspruch 4, dadurch gekennzeichnet, daß zwischen dem zweiten Widerstand (R4) und dem dritten Widerstand (R22) bzw. dem Polysilizium-Gate des ersten MOSFET-Hilfstransistors (T2) eine vierte Diode (D4) angeordnet ist und daß zur Reihenschaltung des zweiten Widerstands (R4) mit der vierten Diode (D4) eine weitere Reihenschaltung eines fünften Widerstands (R5) mit einer fünften Diode (D5) parallelgeschaltet ist, wobei die vierte und die fünfte Diode (D4 bzw. D5) mit zueinander entgegengesetzten Polungen angeordnet sind.

6. Schaltung nach einem der vorhergehenden Ansprüche, **dadurch gekennzeichnet,** daß die Schaltung als Kurzschlußschutzschaltung und/oder übertemperaturschutzschaltung (12) und/oder Überstromschutzschaltung und/oder Überspannungsschutzschaltung (16) eingesetzt wird.

7. Schaltung nach einem der vorhergehenden Ansprüche, **dadurch gekennzeichnet,** daß die gesamte Schaltungsanordnung in einem, eine erste und zweite Hauptoberfläche aufweisenden, scheibenförmigen, einkristallinen, aus Silizium bestehenden Halbleiterkörper monolithisch integriert wird und die verschiedenen Schaltungs- bzw. Schutzelemente eindiffundiert sind.

## Claims

1. Circuit for protecting a MOSFET power transistor (T1) having a plurality of part transistors connected in parallel with one another, having a source connecting terminal (S), a drain connecting terminal (D), one input terminal (G) of the MOSFET power transistor (Tl) being connected via a first ohmic resistor (R1) to its polysilicon gate, a first MOSFET auxiliary transistor (T2) being connected by its source electrode to the source electrode of the MOSFET power transistor (T1) and by its drain electrode to the polysilicon gate of the MOSFET power transistor (T1), the polysilicon gate of the first MOSFET auxiliary transistor (T2) being connected on the one hand via a second ohmic resistor (R21) to the input terminal (G) and on the other hand via a series circuit of a third resistor (R22) and a protecting diode (D1) to the drain connecting terminal (D) of the MOSFET power transistor (T1), the polysilicon gate of the first MOSFET auxiliary transistor (T2) being connected to one of the plates of a capacitor (C1), the other plate of which is connected to the source electrode of the MOSFET auxiliary transistor (T2), characterized in that a second MOSFET auxiliary transistor (T3) is connected by its bulk electrode to the source electrode of the MOSFET power transistor (T1), the source electrode of the second MOSFET auxiliary transistor (T3) is connected to the gate electrode of a third MOSFET auxiliary transistor (T4) and the polysilicon gate of the MOSFET power transistor (T1), the drain electrode of the second MOSFET auxiliary transistor (T3) is connected to the input terminal (G) of the MOSFET power transistor (T1) and the gate electrode of the second MOSFET auxiliary transistor (T3) is connected on the one hand to the drain electrode of the second MOSFET auxiliary transistor (T3) and on the other hand to the source electrode of the third MOSFET auxiliary transistor (T4), the drain electrode of the third MOSFET auxiliary transistor (T4) is connected to the polysilicon gate of the MOSFET power transistor (T1), and the bulk electrode of the third MOSFET auxiliary transistor (T4) is connected to the source electrode of the MOSFET power transistor (T1).

2. Circuit according to Claim 1, characterized in that the drain electrode and gate electrode of a fourth MOSFET auxiliary transistor (T5) are connected on the one hand via the ohmic resistor (R21) to the input terminal (G) and on the other hand via the series circuit of the ohmic resistor (R22) to the protecting diode (D1) and the drain connecting terminal (D) of the MOSFET power transistor (T1), the source electrode of the MOSFET auxiliary transistor (T5) is connected to the input terminal (G) and the bulk electrode of the MOSFET auxiliary transistor (T5) is connected to the source connecting terminal (S) of the MOSFET power transistor (T1).

3. Circuit according to one of the preceding claims, characterized in that the MOSFET auxiliary transistors (T3, T4, T5) are disposed in freely selectable, arbitrary combinations.

4. Circuit for protecting a MOSFET power transistor (T1) having a plurality of part transistors connected in parallel with one another, having a source connecting terminal (S), a drain connecting terminal (D), one input terminal (G) of the MOSFET power transistor (T1) being connected via a first ohmic resistor (R2) to its polysilicon gate, a first MOSFET auxiliary transistor (T2) being connected by its source electrode to the source electrode of the MOSFET power transistor (T1) and by its drain electrode to the polysilicon gate of the MOSFET power transistor (T1), the polysilicon gate of the first MOSFET auxiliary transistor (T2) being connected on the one hand via a second ohmic resistor (R4) to the input terminal (G) and on the other hand via a series circuit of a third resistor (R22) and a protecting diode (D1) to the drain connecting terminal (D) of the MOSFET power transistor (T1), the polysilicon gate of the first MOSFET auxiliary transistor (T2) being connected to one of the plates of a capacitor (C1), the other plate of which is connected to the source electrode of the first MOSFET auxiliary transistor (T2), characterized in that a second diode (D2) is disposed between the first resistor (R2) and the drain connection of the first auxiliary transistor (T2) and respectively the polysilicon gate of the MOSFET power transistor (T1), and in that with the series circuit of the first resistor (R2) and the second diode (D2) there is connected in parallel a further series circuit of a fourth resistor (R3) and a third diode (D3), the second and third diodes (D2 and D3 respectively) being disposed such that they are mutually oppositely biased.

5. Circuit according to Claim 4, characterized in that a fourth diode (D4) is disposed between the second resistor (R4) and the third resistor (R22) and respectively the polysilicon gate of the first MOSFET auxiliary transistor (T2), and in that with the series circuit of the second resistor (R4) and the fourth diode (D4) there is connected in parallel a further series circuit of a fifth resistor (R5) and a fifth diode (D5), the fourth and the fifth diodes (D4 and D5 respectively) being disposed such that they are mutually oppositely biased.

6. Circuit according to one of the preceding claims, characterized in that the circuit is used as short-circuit protecting circuit and/or excess temperature protecting circuit (12) and/or excess current protecting circuit and/or excess voltage protecting circuit (16).

7. Circuit according to one of the preceding claims, characterized in that the entire circuit arrangement is monolithically integrated in a wafer-shaped, monocrystalline semiconductor body which exhibits a first and a second main surface and which comprises silicon and the various circuit elements and protecting elements respectively are diffused in.

## Revendications

1. Circuit de protection d'un transistor de puissance MOSFET (T1) avec un grand nombre de transistors partiels branchés en parallèle, une borne de source (S), une borne de drain (D), une borne d'entrée (G) du transistor de puissance MOSFET (T1) étant reliée par une première résistance ohmique (R1) à sa grille de polysilicium, un premier transistor auxiliaire MOSFET (T2) étant relié par son électrode de source à l'électrode de source du transistor de puissance MOSFET (T1) et par son électrode de drain à la grille de polysilicium du transistor de puissance MOSFET (T1), la grille de polysilicium du premier transistor auxiliaire MOSFET (T2) étant reliée d'une part par une seconde résistance ohmique (R21), à la borne d'entrée (G) et, d'autre part, par le montage en série d'une troisième résistance (R22) et d'une diode de protection (D1), à la borne de drain (D) du transistor de puissance MOSFET (T1), la grille de polysilicium du premier transistor auxiliaire MOSFET (T2) étant reliée à un revêtement d'une capacité (C1) dont l'autre revêtement est relié à l'électrode de source du transistor auxiliaire MOSFET (T2),
caractérisé en ce qu'
un second transistor auxiliaire MOSFET (T3) est relié par son électrode bulk à l'électrode de source du transistor de puissance MOSFET (T1), l'électrode de source du second transistor auxiliaire MOSFET (T3) étant reliée à l'électrode de grille d'un troisième transistor auxiliaire MOSFET (T4) et à la grille de polysilicium du transistor de puissance MOSFET (T1), l'électrode de drain du second transistor auxiliaire MOSFET (T3) étant reliée à la borne d'entrée (G) du transistor de puissance MOSFET (T1) et l'électrode de grille du second transistor auxiliaire MOSFET (T3) étant reliée d'une part à l'électrode de drain du second transistor auxiliaire MOSFET (T3), et d'autre part, à l'électrode de source du troisième transistor auxiliaire MOSFET (T4), l'électrode de drain du troisième transistor auxiliaire MOSFET (T4) étant reliée à la grille de polysilicium du transistor de puissance MOSFET (T1) et l'électrode bulk du troisième transistor auxiliaire MOSFET (T4) étant reliée à l'électrode de source du transistor de puissance MOSFET (T1).

2. Circuit selon la revendication 1,
caractérisé en ce que
les électrodes de drain et de grille d'un quatrième transistor auxiliaire MOSFET (T5) sont reliées d'une part par la résistance ohmique (R21), à la borne d'entrée (G) et d'autre part, par le montage en série de la résistance ohmique (R22) et de la diode de protection (D1), à la borne de drain (D) du transistor de puissance MOSFET (T1), l'électrode de source du transistor auxiliaire MOSFET (T5) étant reliée à la borne d'entrée (G) et l'électrode bulk du transistor auxiliaire MOSFET (T5) étant reliée à la borne de source (S) du transistor de puissance MOSFET (T1).

3. Circuit selon l'une des revendications précédentes,
caractérisé en ce que
les transistors auxiliaires MOSFET (T3, T4, T5) sont susceptibles d'être réunis dans des conditions quelconques librement choisies.

4. Circuit de protection d'un transistor de puissance MOSFET (T1) comprenant un grand nombre de transistors partiels branchés en parallèle, une borne de source (S), et une borne de drain (D), la borne d'entrée (G) du transistor de puissance MOSFET (T1) étant reliée par l'intermédiaire d'une première résistance ohmique (R2) à sa grille en polysilicium, un premier transistor auxiliaire MOSFET (T2) étant relié par son électrode de source à l'électrode de source du transistor de puissance MOSFET (T1) et par son électrode de drain à la grille en polysilicium du transistor de puissance MOSFET (T1), la grille en polysilicium du premier transistor auxiliaire MOSFET (T2) étant reliée d'une part par une seconde résistance ohmique (R4) à la borne d'entrée (G) et d'autre part, par le montage en série d'une troisième résistance (R22) et d'une diode de protection (D1) à la borne de drain (D) du transistor de puissance MOSFET (T1), la grille de polysilicium du premier transistor auxiliaire MOSFET (T2) étant reliée à un revêtement d'un condensateur (C1) dont l'autre revêtement est relié à l'électrode de source du premier transistor auxiliaire MOSFET (T2),
caractérisé en ce qu'
entre la première résistance (R2) et la borne de drain du premier transistor auxiliaire (T2) ou la grille de polysilicium du transistor de puissance MOSFET (T1), il y a une seconde diode (D2) et, pour le montage en série de la première résistance (R2) et de la seconde diode (D2), il y a en parallèle, un autre branchement en série comprenant une quatrième résistance (R3) et une troisième diode (D3), la seconde et la troisième diode (D2, D3) étant montées avec des polarités opposées.

5. Circuit selon la revendication 4,
caractérisé en ce qu'
entre la seconde résistance (R4) et la troisième résistance (R22) ou la grille en polysilicium du premier transistor auxiliaire MOSFET (T2), il y a une quatrième diode (D4) et, pour le branchement en série de la seconde résistance (R4) et de la quatrième diode (D4), on a en parallèle un autre branchement en série d'une cinquième résistance (R5) et d'une cinquième diode (D5), la quatrième et la cinquième diodes (D4, D5) étant montées avec des polarités opposées.

6. Circuit selon l'une des revendications précédentes,
caractérisé en ce que
le circuit est appliqué comme circuit de protection contre les courts-circuits et/ou comme circuit de protection contre les surtempératures (12) et/ou comme circuit de protection contre les surintensités et/ou comme circuit de protection contre les surtensions (16).

7. Circuit selon l'une des revendications précédentes,
caractérisé en ce que
l'ensemble du circuit est intégré dans un corps semiconducteur en silicium monocristallin en forme de disque ayant une première et une seconde surface dans lesquelles sont diffusés les différents éléments de circuit et éléments de protection.
